# EUROPEAN PATENT SPECIFICATION

(11) **EP 2 835 701 B1**
(45) Date of publication and mention of the grant of the patent: **28.06.2017**
(21) Application number: 14179585.6
(22) Date of filing: 01.08.2014
(51) Int. Cl.: G05B 19/042, H01L 21/02

(54) **System and method for modular controller assembly supporting redundant configurations**
System und Verfahren für modulare Steuerungsanordnung zur Unterstützung redundanter Konfigurationen
Système et procédé d'un ensemble de commande modulaire supportant des configurations redondantes

(30) Priority: 08.08.2013 US 201313962798
(43) Date of publication of application: 11.02.2015
(73) Proprietor: General Electric Company, Schenectady, NY 12345 (US)
(72) Inventor: Alley, Daniel Milton, Salem, VA 24153 (US); Lovell, Alan Carroll, Salem, VA 24153 (US); Moore, Christopher Todd, Salem, VA 24153 (US)
(74) Representative: Fischer, Jens Peter

(56) References cited:
- EP-A1- 2 180 389
- WO-A1-95/08912
- US-A1- 2007 168 058
- US-A1- 2012 104 295
- US-B1- 7 870 299

## Description

The subject matter disclosed herein relates to controllers, such as industrial controllers for turbine systems, power plants, and gasification systems.

In control systems, various sensors measure and provide feedback regarding conditions of a device (e.g., a turbine system) to a controller. Processors of the controller use the feedback to control the device. A control system may use an acquisition card with a dedicated sensor to monitor a system. The dedicated sensor provides the feedback to the processors. Additional sensors may be added with corresponding additional acquisition cards. The acquisition cards may have conversion units to convert raw feedback from the sensors to data signals. A dedicated processor on each acquisition card processes the data signals. Unfortunately, the accuracy of the conversion unit and dedicated processor on an acquisition card may degrade over time. Additionally, dedicated processors on acquisition cards may increase costs of acquisition cards and inefficiently utilize processors of the control system.

EP 2 180 389 A1 relates to process monitoring systems and, more particularly, to a number of pluggable bases which may be connected together in a monitoring system configuration and where the bases may comprise different levels of redundancy.

Certain embodiments commensurate in scope with the originally claimed invention are summarized below. These embodiments are not intended to limit the scope of the claimed invention, but rather these embodiments are intended only to provide a brief summary of possible forms of the invention. Indeed, the invention may encompass a variety of forms that may be similar to or different from the embodiments set forth below.

In a first embodiment, a system includes a head board with a first head processor, a first carrier board, and a first junction. The first carrier board includes a first plurality of connectors configured to communicatively couple the head board to one or more first acquisition modules with a first attachment pattern. The first carrier board is configured in a first simplex or a first redundant configuration based at least in part on the first attachment pattern. The first junction is configured to removably couple the first carrier board with a terminator or to removably couple the first carrier board with a second carrier board.

In a second embodiment, a system includes a head board with a first head processor and a first carrier board. The first carrier board has a first terminal block and a second terminal block. The first terminal block is communicatively coupled to the head board, a first connector, a second connector, and a third connector. The first connector is configured to couple with a first acquisition module in a first simplex mode, a first dual redundancy mode, or a first triple redundancy mode, the second connector is configured to couple with a second acquisition module in the first dual redundancy mode or the first triple redundancy mode, and the third connector is configured to couple with a third acquisition module in the first triple redundancy mode. The second terminal block is communicatively coupled to the head board and to a fourth connector. The fourth connector is configured to couple with the second acquisition module in the first simplex mode.

In a third embodiment, a method includes receiving a first sensor feedback at a first carrier board, processing the first sensor feedback into first data signals, and communicating the first data signals to one or more head processors. The first sensor feedback is processed into first data signals with one or more first acquisition modules coupled to the first carrier board, which is configured in a first mode. The first mode includes a simplex mode or a redundant mode based at least in part on a first attachment pattern of the one or more first acquisition modules to the first carrier board. The redundant mode directs the first sensor feedback to a first plurality of redundant acquisition modules of the one or more first acquisition modules.

These and other features, aspects, and advantages of the present invention will become better understood when the following detailed description is read with reference to the accompanying drawings in which like characters represent like parts throughout the drawings, wherein:
FIG. 1 illustrates a block diagram view of an embodiment of a controller assembly having a processor coupled to a sensor via a terminal block;
FIG. 2 illustrates a block diagram view of an embodiment of the controller assembly of FIG. 1 with one or more carrier boards;
FIG. 3 illustrates a block diagram view of an embodiment of the controller assembly of FIG. 1 with carrier boards and acquisition modules in various redundancy modes;
FIG. 4 illustrates a block diagram view of an embodiment of the controller assembly with carrier boards configurable in simplex, dual, and triple redundancy modes;
FIG. 5 illustrates a block diagram of an embodiment of the controller assembly with carrier boards configurable in simplex and dual redundancy modes; and
FIG. 6 illustrates a flow diagram of an embodiment of a method for assembling and operating the controller assembly of FIG. 4.

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements.

Various embodiments of the present disclosure include a controller assembly with one or more acquisition modules that are each configurable in simplex or redundant configurations. The controller assembly includes a head board and one or more carrier boards. Each carrier board may be coupled to one or more acquisition modules. The acquisition modules receive raw feedback signals from one or more coupled sensors. The physical arrangement (e.g., attachment pattern) of the acquisition modules to the carrier board may automatically configure the carrier board in a particular redundancy mode. In a simplex configuration, each acquisition module receives raw feedback signals from a respective set of coupled sensors. In a redundant configuration, two or more acquisition modules of a carrier board receive raw feedback signals from a common set of sensors coupled to the carrier board. In some embodiments, acquisition modules arranged on a carrier board in a redundant mode may substantially prevent coupling additional acquisition modules in a simplex mode. Likewise, in some embodiments, multiple acquisition modules arranged on a carrier board in a simplex mode may substantially prevent coupling additional acquisition modules in a redundant mode. The carrier boards may be modular, thereby enabling multiple carrier boards of a common head board to each have different redundancy configurations. Additionally, the head board may have multiple processors to receive data signals from one or more acquisition modules. The acquisition modules may be redundantly coupled to more than one processor. The redundancy of the acquisition modules and/or the processors reduces measurement errors and increases the flexibility of utilizing the system in various operating environments. Additionally, the various redundancy configurations enables the control system to perform desired control and monitoring operations despite one or more underperforming (e.g., non-functional) components, which may enable a decrease in system down time and/or maintenance frequency. In some embodiments, acquisition modules and/or processors may be hot-swappable components that are added or replaced during operation without powering down the controller.

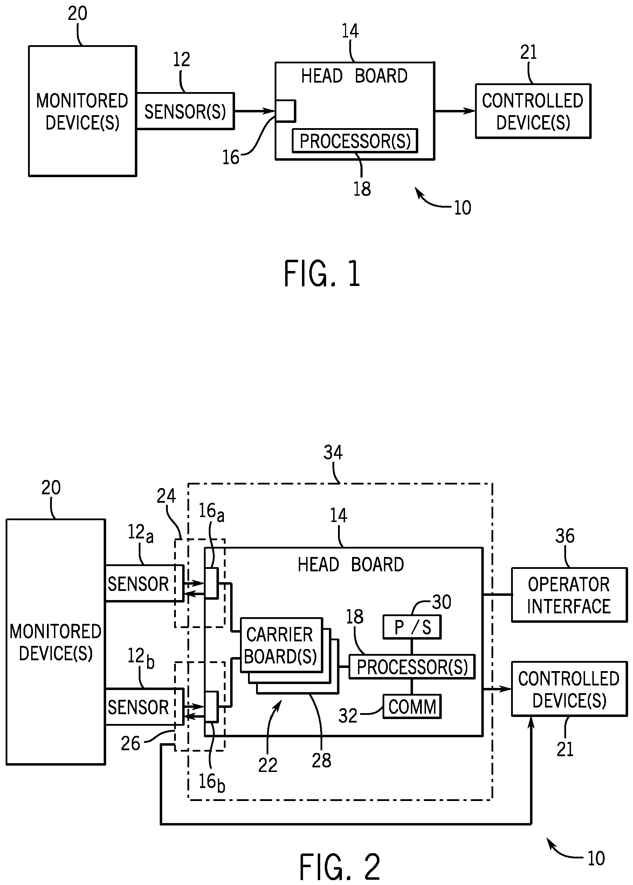

Turning to the drawings, FIG. 1 illustrates an embodiment of a controller system 10. In some embodiments, the controller system 10 may be a power management system in a power plant, gasification system, turbine system, or other suitable system. The controller system 10 includes one or more sensors 12 that couple to a head board 14 through one or more terminal blocks 16. In certain embodiments, the one or more sensors 12 may detect temperatures (e.g., thermocouples, resistor temperature detectors (RTDs)), pressures, flow rates, material compositions, clearances, flames, electrical properties (e.g., current, voltage) of certain signals, or other suitable properties and may transmit sensed information to a respective terminal block 16 in one of a variety of formats. For example, various embodiments of the terminal blocks 16 may receive information from various types of sensors 12 that send information using various voltages, such as 2.5 to 5V, -10V to 10 V, 30mV to 10V, -100mV to 100mV, or other suitable voltages. Additionally, or alternatively, some embodiments of the terminal blocks 16 may receive signals from the sensors 12 using a variety of currents such as 4-20 mA, 10mA, or other suitable currents. Additionally, certain embodiments of the sensors 12 may transmit signals from the terminal blocks 16 using a highway addressable remote transducer (HART) protocol or other similar protocols. In some embodiments, one or more of the terminal blocks 16 may have programmable universal I/O terminals configured to receive or transmit digital (e.g., discrete) signals or analog signals.

The one or more terminal blocks 16 provide a connection between the one or more sensors 12 and the head board 14. As discussed in detail below, the one or more terminal blocks 16 provide a link between the sensor 12 and one or more processors 18. In some embodiments, the one or more processors 18 may include a microcontroller, a microprocessor, a programmable logic controller (PLC), or another suitable processor. Accordingly, through the one or more terminal blocks 16, the processor 18 may receive signals from the one or more sensors 12 that sense various measurements within the controller system 10. Additionally, the one or more terminal blocks 16 may have terminals arranged in channels to receive sensed parameters from the one or more sensors 12. Furthermore, one or more channels may be used to communicate with one or more sensors 12. For example, in some embodiments, a sensor 12 (e.g., RTD) may be connected to the head board 14 through one, two, three, four or more channels of a terminal block 16. In certain embodiments, one channel may encompass three terminals, but other embodiments may include channels encompassing one, two, three, four, or more terminals of a terminal block 16. Moreover, in some embodiments, each sensor 12 may connect to a single channel, but other embodiments may include sensors 12 that span two or more channels, thus spanning two or more terminals.

In some embodiments, the one or more sensors 12 sense measurements from one or more monitored devices 20. The one or more monitored devices 20 may include one or more devices within a power plant, a chemical plant, or other industrial facility. For example, the monitored devices 20 may include components of a generator, a turbine system (e.g., compressor blades, turbine blades, bearings, combustors, fuel nozzles, etc.), a compression system, a pump, a reactor, a gasifier, a gas treatment system, or any combination thereof. In various embodiments, the processor 18 may use a sensed parameter (e.g., temperature, pressure, flow rate, material composition, etc.) from the one or more sensors 12, to control one or more controlled devices 21. Within the controller system 10, the controlled devices 21 may include any monitored device 20 or other device that depends upon or affects the sensed measurements.

As may be appreciated, signals from the one or more sensors 12 may not be transmitted directly to the processor 18. In some embodiments, the signals from the one or more sensors 12 with a first voltage and/or current are converted to signals with a second voltage and/or current for the processor 18. Accordingly, FIG. 2 illustrates a controller system 10 that includes an acquisition system 22. In the illustrated embodiment, the controller system 10 includes two sensors 12, but other embodiments may include one, three, four, or more sensors. Additionally, the illustrated embodiment of the controller system 10 includes a first channel 24 that couples the head board 14 to a respective first sensor 12a. The illustrated embodiment of the controller system 10 also includes a second channel 26 that couples the head board 14 to a respective second sensor 12b. As discussed above, each sensor 12 may be coupled to the terminal block 16 via multiple channels, and each channel may include multiple terminals. In some embodiments, multiple sensors (e.g., 12a and 12b) may be coupled to the same terminal block 16 through different channels (e.g., 24 and 26).

The illustrated embodiment of the acquisition system 22 includes one or more carrier boards 28 the converts the signals from the sensor(s) 12 to voltages and/or currents that are suitable for processing by the processor 18. As discussed below, each carrier board 28 may include one or more acquisition modules to convert the signals from the sensor(s) 12. For example, the acquisition modules of the carrier boards 28 may convert raw (e.g., analog) feedback signals from the sensors 12 to discrete data signals. As discussed in detail below, the carrier boards 28 may receive inputs from one or more sensors 12 of various sensor types. One or more acquisition modules of the carrier boards 28 convert the signals from each of the sensors 12 to signals suitable for the processor 18 to process. For example, the sensors 12 may be any sensor type, such as sensors 12 that send 4-20 milliamp signals, thermocouples, RTDs, HART devices, or other suitable sensor types. In some embodiments, the one or more acquisition modules of the carrier boards 28 may convert signals from the processor 18 to output voltages and/or currents that are suitable for controlling the monitored devices 20 and/or the controlled devices 21. In other words, the one or more carrier boards 28 (along with the terminal blocks 16) may provide a universal IO point that enables the use of various sensor types to connect to the head board 14 and the one or more processors 18 without implementing dedicated terminal blocks 16 for each sensor type.

In some embodiments, the carrier boards 28 may include voltage and/or current conversion circuitry that may be implemented using application specific integrated circuits (ASICs), field programmable gate arrays (FPGAs), or other suitable circuitry. Additionally, in some embodiments, the one or more carrier boards 28 may include further processing circuitry that may perform additional manipulation on the sensed signals from the sensor(s) 12. For example, certain embodiments of the carrier boards 28 may include digital-to-analog converters (DAC) and/or analog-to-digital converters (ADC).

Various components of the head board 14 may support the one or more carrier boards 28. In some embodiments, the one or more processors 18 may be redundantly coupled to the one or more carrier boards 28, so that at least two of the processors 18 execute substantially the same instructions for the data signals corresponding to any sensor 12. The respective outputs of the redundant processors 18 may be compared to verify the sensor measurements and/or to identify potential errors or maintenance issues regarding a sensor 12, a carrier board 28, an acquisition module, and so forth. The redundant processors 18 may enable the head board 14 to continue operation despite one or more of the redundant processors 18 not operating for any reason. A power supply 30 may distribute power to drive the one or more processors 18 and the one or more carrier boards 28. In some embodiments, the power supply 30 may distribute power through one carrier board 28 to another carrier board 28, and/or to distribute power to one or more sensors 12. Communications circuitry 32 enables the one or more processors to transfer signals between the head board 14 and other devices (e.g., sensor 12, controlled device 21) or systems of the controller system 10. The communications circuitry 32 may enable wired and/or wireless communication between the head board 14 and other devices or systems of the controller system 10. In some embodiments, the communication circuitry 32 couples with the one or more carrier boards 28 to facilitate communications between acquisition modules of the carrier board 28 and the processors 18.

The head board 14 may be housed in a single physical enclosure 34 (e.g., a personal computer, server, controller cabinet, or other suitable controller assembly) or may include multiple enclosures (e.g., distributed control system). In some embodiments, the controller system 10 may include multiple head boards 14 in one or more enclosures 34. One or more head boards 14 may be mounted on control panels within an enclosure 34. The one or more sensors 12, the one or more monitored devices 20, and/or the one or more controlled devices 21 may be internal or external to the enclosure 34. An operator interface 36 may display sensed measurements from the one or more sensors 10, commands issued through the acquisition system 22, and/or feedback on the monitored devices 20 or controlled devices 21. An operator may utilize the operator interface 36 to maintain, control, and/or monitor the controller system 10.

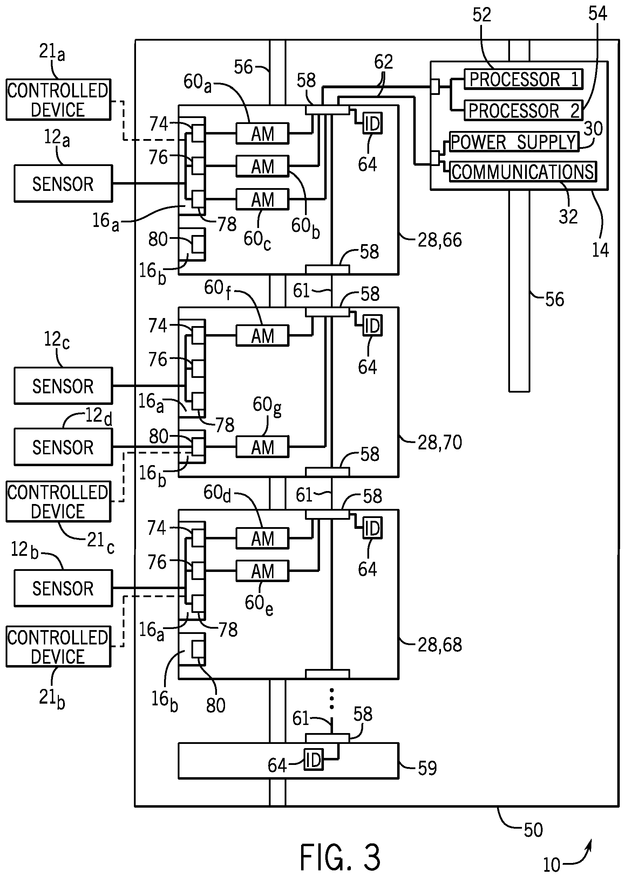

FIG. 3 illustrates an embodiment of a control panel 50 of the controller system 10. The head board 14 with the first processor 52 and second processor 54 is separate from the carrier boards 28. In some embodiments, the head board 14 may be integrated with one or more carrier boards 28. As may be appreciated, the one or more carrier boards 28 and the head board 14 may be mounted to the panel 50 via one or more mounting features 56 (e.g., DIN rails). Junctions 58 communicatively couple each carrier board 28 to the head board 14. The junctions 58 are electrically connected to one or more acquisition modules 60 of each carrier board 28. In some embodiments, the junction 58 of one carrier board 28 may couple directly or indirectly (e.g., via wired or wireless connection) to another carrier board 28 or to the head board 14. For example, multiple carrier boards 28 may be coupled together in series to the head board 14. The head board 14 may be configured to support connections with approximately 8, 16, 24, or more carrier boards 28. In some embodiments, each carrier board 28 has mating junctions 58 to facilitate series coupling of carrier boards 28. The mating junctions 58 may directly interface together, and/or interface via wired connections 61. A similar arrangement of carrier board components, such as the junctions 58 and terminal blocks 16a, 16b, may enable one carrier board 28 to be readily switched with another carrier board 28. Each carrier boards 28 may be modular and removably couple with other carrier boards 28 via the junctions 58. A terminator 59 may couple with a junction 58 at the end of a series of carrier boards 28. As may be appreciated, the terminator 59 may close a communication loop between the head board 14 and a series of carrier boards 28, thereby facilitating communication through the carrier boards 28 via the junctions 58. In some embodiments, an identifier 64 in the terminator 59 enables the head board 14 to determine a quantity of serially connected carrier boards 28 and/or to determine the end of a series of carrier boards 28.

The junctions 58 enable the carrier boards 28 to communicate with the head board 14. The acquisition modules 60 transfer data signals to the one or more processors 18 of the head board 14 through the junction 58, and may receive power and instructions from the head board 14 through the junction 58. One or more signal lines 62 transfer data signals between the junctions 58 and the head board 14. In some embodiments, the signal lines 62 may be dedicated for certain functions, such as input from the acquisition modules 60, output from the head board 14, power to the carrier boards 28, and/or power to the sensors 12. The head board 14 may communicate with each carrier board 28 in series or in parallel via the signal lines 62. In some embodiments, each carrier board 28 may be identified via an identifier 64 (e.g., coded chip). Communications with a particular carrier board 28 may be coordinated with the identifier 64. As may be appreciated, the identifier 64 may facilitate serially addressing each of the carrier boards 28 along shared signal lines 62. In some embodiments, dedicated signal lines 62 for each carrier board 28 facilitate parallel communication with the head board 14.

The first and second processors 52, 54 may be shared among the one or more carrier boards 28. Some embodiments may include more than two processors 18 (e.g., 3, 4, 5, 6, or more processors). The acquisition modules 60 may convert the raw feedback signals to data signals to transmit along the signal lines 62, and the processors 52, 54 of the head board 14 execute instructions with the data signals. In some embodiments, the acquisition modules 60 may convert data signals from the processors 52, 54 to output control signals to control one or more controlled devices 21. Sharing the processors 52, 54 may reduce the operations performed on the acquisition modules 60, which may reduce the size, cost, and/or heat generation of the acquisition modules 60. In some embodiments, sharing the processors 52, 54 among acquisition modules 60 may increase the utilization of the processing capability of the controller system 10.

The first and second processors 52, 54 of the head board 14 may be redundantly coupled to the one or more carrier boards 28. That is, the first processor 52 may receive data signals and execute instructions with the data signals to produce a first processor output, and the second processor 54 may receive the same data signals and execute substantially the same instructions with the data signals to produce a second processor output. The first processor output and the second processor output may be substantially the same (e.g., identical), and differences between the processor outputs may indicate a fault within one of the processors 52, 54. The redundant processors 52, 54 may increase the robustness of the head board 14 against errors. Multiple processors 18 of the head board 14 may be redundantly coupled to the carrier boards 28, so that the controller system 10 may receive and process sensor feedback from every sensor 12 despite removing, replacing, or powering down one or more processors 18 of the head board 14.

Over the signal lines 62, each carrier board 28 communicates data signals that are based at least in part on raw feedback signals from one or more sensors 12. A carrier board 28 may be coupled to a sensor 12 in various redundancy modes through one or more acquisition modules 60. FIG. 3 illustrates an example in which a first carrier board 66 is configured in a triple redundancy mode (e.g., triple modular redundancy (TMR)) with three acquisition modules 60, a second carrier board 68 is configured in a dual redundancy mode with two acquisition modules 60, and a third carrier board 70 is configured with two acquisition modules 60 each in a simplex mode. In some embodiments, the carrier boards 28 are configured in a redundancy mode based at least in part on physical connections between the acquisition modules 60 and the terminal blocks 16. The physical arrangement (e.g., attachment pattern) of the acquisition modules 60 to a carrier board 28 may determine the configured redundancy mode of the carrier board 28. The physical arrangement of the acquisition modules 60 couples each acquisition module 60 to a particular terminal block 16. Multiple acquisition modules 60 coupled to the same terminal block 16 are redundantly configured to receive the same feedback signals and/or to transmit the same control signals. Acquisition modules 60 coupled to different terminal blocks (e.g., first terminal block 16a and second terminal block 16b) receive different feedback signals and/or transmit different control signals, and are thus not redundant to one another.

In the triple redundancy mode of the first carrier board 66, three acquisition modules 60a, 60b, 60c receive raw feedback signals from the same sensor 12a coupled to the first terminal block 16a. In some embodiments, one of the three acquisition modules 60a, 60b, 60c transmits a control signal from the first terminal block 16a to a coupled controlled device 21. The acquisition modules 60a, 60b, 60c are coupled to the first terminal block 16a via a first set of connectors 74, 76, 78 respectively. The second terminal block 16b enables the first carrier board 66 to couple with another sensor 12. A second set of connectors 80 of the second terminal block 16b on the first carrier board 66 may be vacant. In some embodiments, respectively connecting the acquisition modules 60a, 60b, 60c to the connectors of the same terminal block (e.g., first terminal block 16) automatically configures the first carrier board 66 into the triple redundancy mode. In some embodiments, the first acquisition module 60a may be designated a master acquisition module, and the second and third acquisition modules 60b, 60c are designated as slave acquisition modules. The master-slave designations may be determined via a master connector (e.g., connector 74) or via an adjustment to the carrier board 28, such as a jumper switch.

Each of the acquisition modules 60a, 60b, 60c may be the same type of acquisition module 60 configured to receive and process the same type of raw feedback signals from the sensors 12 or data signals from the head board 14. In other words, each of the acquisition modules 60a, 60b, 60c may be configured to perform substantially the same (e.g., identical) operations and achieve substantially the same (e.g., identical) results from a given set of raw feedback signals or data signals. For example, if the first acquisition module 60a is configured to determine temperature and pressure in a combustor, then the second and third acquisition modules 60b, 60c are also configured to determine temperature and pressure in the combustor from the same sensor feedback signals. As may be appreciated, age, wear, or imperfections of materials or manufacture may cause an acquisition module to introduce errors into its output. The outputs of each of the acquisition modules 60a, 60b, 60c may be compared at the junction 58, carrier board 28, or the head board 14. Differences between one of the outputs and another output may indicate a fault of a component (e.g., acquisition module 60a, 60b, or 60c) on the first carrier board 66. For example, if the second acquisition module 60b produces a first output from a raw feedback signal of the sensor 12a or data signal from the head board 14, and the first and third acquisition modules 60a, 60c, produce a second output (e.g., different from the first output) from the same raw feedback signal of the sensor 12a or data signal from the head board 14, the output comparison would identify a probable error with the second acquisition module 60b. Accordingly, the triple redundancy enables an error of one acquisition module 60 to be identified while the other redundant acquisition modules 60 continue in operation, thereby enabling the controller system 10 to operate for a time until maintenance despite the error.

As may be appreciated, carrier boards 28 configured in various redundancy modes may utilize multiple acquisition modules 60 to improve the robustness of the data signal output from acquisition modules to the head board 14 or control signal output from acquisition modules to the controlled devices 21. Redundantly configured carrier boards 28 have multiple acquisition modules 60 to redundantly process inputs from sensors 12 or outputs to controlled devices 21. In some embodiments, a carrier board 28 coupled to a controlled device 21 is redundantly configured with multiple acquisition modules 60. During operation, each of the acquisition modules (e.g., 60a, 60b, 60c) may produce control signals based on data signals from the head board 14; however, output control signals from only one of the acquisition modules (e.g., first acquisition module 60a) may be transmitted to the controlled device 21a at a time. The other acquisition modules (e.g., second and third acquisition modules 60b, 60c) may remain online as backups to the active acquisition module. If a fault is found with the first acquisition module 60a, the first carrier board 66 may deactivate the first acquisition module 60a and activate one of the redundant acquisition modules (e.g., second or third acquisition modules 60b, 60c). In a similar way, the triple redundancy first carrier board 66 may deactivate the second acquisition module 60b if a fault is found, and activate another redundant acquisition module (e.g., third acquisition module 60c). Accordingly, the redundantly configured first carrier board 66 may increase the accuracy and/or reliability of control signals provided to the controlled device 21a. Carrier boards 28 configured in other redundancy modes (e.g., dual) may utilize redundant acquisition modules 60 in a similar manner.

In the dual redundancy mode, two acquisition modules 60d and 60e receive raw feedback signals from the same sensor 12b coupled to the first terminal block 16a of the second carrier board 68. In some embodiments, one of the two acquisition modules 60d, 60e may transmit control signals to the controlled device 21b coupled to the first terminal block 16a of the second carrier board 68. The acquisition modules 60d and 60e are coupled to the first terminal block 16a of the second carrier board 68 via connectors 74 and 76. Connector 78 of the first terminal block 16a and the second set of connectors 80 of the second terminal block 16b may be vacant when the second carrier board 68 is configured with a dual redundancy. In some embodiments, connecting the acquisition modules 60d and 60e to any two of the connectors (e.g., 74, 76, 78) of the same terminal block (e.g., first terminal block 16a) may automatically configure the second carrier board 68 into the dual redundancy mode.

Each of the redundant acquisition modules 60d and 60e may be the same type (e.g., oxygen detector) of acquisition module 60 configured to receive and process the same type of raw feedback signals from the sensor 12b or to receive and process the same type of data signals from the head board 14. The acquisition modules 60d and 60e may be of the same type or a different type than the acquisition modules 60a, 60b, 60c of the first carrier board 66. The outputs of each of the acquisition modules 60d and 60e may be compared at the junction 58, the carrier board 28, or the head board 14. Differences between the output from the acquisition modules 60d and 60e may indicate a fault of one of the components (e.g., acquisition module 60d or 60e) on the second carrier board 68. For example, if the fourth acquisition module 60d produces a first output from a raw feedback signal or data signal, and the fifth acquisition module 60e produces a different second output from the same raw feedback signal or data signal, the output comparison would identify a probable error in one of the acquisition modules 60d or 60e because of the difference. Accordingly, the dual redundancy enables the controller system 10 to identify that a fault has occurred in one of the acquisition modules. In some embodiments, both outputs may be utilized until the appropriate acquisition module is repaired or replaced. Additionally, or in the alternative, the head board 14 may determine which output to utilize and which output to ignore or discard based on the difference or output from other acquisition modules 60.

In the simplex mode, only one acquisition module 60 receives raw feedback signals from each sensor 12 coupled to a terminal block 16 of the carrier board 28. In other words, the acquisition module 60 of a carrier board 28 in the simplex mode does not have another acquisition module 60 redundantly receiving the same raw feedback signals. The third carrier board 70 has a sixth acquisition module 60f coupled to the first terminal block 16a (e.g., via a connector 74, 76, or 78) and a seventh acquisition module 60g coupled to the second terminal block 16b (e.g., via a connector 80). The sixth acquisition module 60f receives raw feedback signals from sensor 12c, and the seventh acquisition module receives feedback signals from sensor 12d. The sensors 12c and 12d may be different and the sixth acquisition module 60f may be a different type (e.g., temperature) than the seventh acquisition module 60g (e.g. pressure). In some embodiments, the sixth acquisition module 60f may receive raw feedback signals from the sensor 12c, and the seventh acquisition module 60g may transmit control signals to a controlled device 21c. In some embodiments, connecting acquisition modules 60 to more than one terminal block 16 on a carrier board 28 automatically configures the carrier board 28 in a simplex mode. One or more of the connectors (e.g., connectors 74, 76, 78) may be vacant while the acquisition modules 60f and 60g is connected to the third carrier board 70.

The first, second, and third carrier boards 66, 68, 70 may have multiple terminal blocks 16 to enable each carrier board to be selectively configured in a simplex mode with one sensor, a simplex mode with two sensors, a dual redundancy mode, or a triple redundancy mode. In some embodiments, a terminal block 16 of a carrier board 28 may have four, five, six, or more connectors, thereby increasing a potential quantity of redundant acquisition modules 60, which may increase the robustness of the controller system 10. Moreover, in some embodiments, more than two acquisition modules 60 may be coupled to a carrier board 28 in a simplex mode via different terminal blocks 16. In some embodiments, an acquisition module 60 may be coupled to a carrier board 28 in a simplex mode via the second terminal block 16b while other acquisition modules 60 are coupled to the same carrier board 28 in a redundancy mode (e.g., dual, triple) via the first terminal block 16a.

In some embodiments, the carrier boards 28 connected to the head board 14 of a control panel 50 may have various redundancy modes. While FIG. 3 illustrates an embodiment with carrier boards 66, 68, 70 having three different redundancy modes, some embodiments may include two or more carrier boards 28 with the same redundancy mode (e.g., simplex, dual, triple). The carrier boards 28 may be redundantly coupled to multiple head boards 14. Thus, in some embodiments, a carrier board 28 may have acquisition modules 60 redundantly configured in a dual or triple redundancy mode, the carrier board 28 may be redundantly coupled to multiple head boards 14, and each head board 14 may have redundant processors 18. Accordingly, embodiments of the controller system 10 are modular to facilitate numerous redundancy configurations to provide a desired level of robustness. For example, the processors 18 of the head board 14 may be modular and interchangeable to facilitate replacing a first head board and first set of processors with a second head board and second set of processors without affecting the performance of the controller system 10. In a similar manner, the carrier boards 28 may be modular and interchangeable to facilitate replacing a first carrier board with a second carrier board without changing the performance or quantity of redundant acquisition modules 60 receiving feedback signals from the coupled sensors 12. In some embodiments, the configurable carrier boards 28 provide flexibility to change a redundancy mode without exchanging the carrier board 28 for another carrier board 28 with a different redundancy mode.

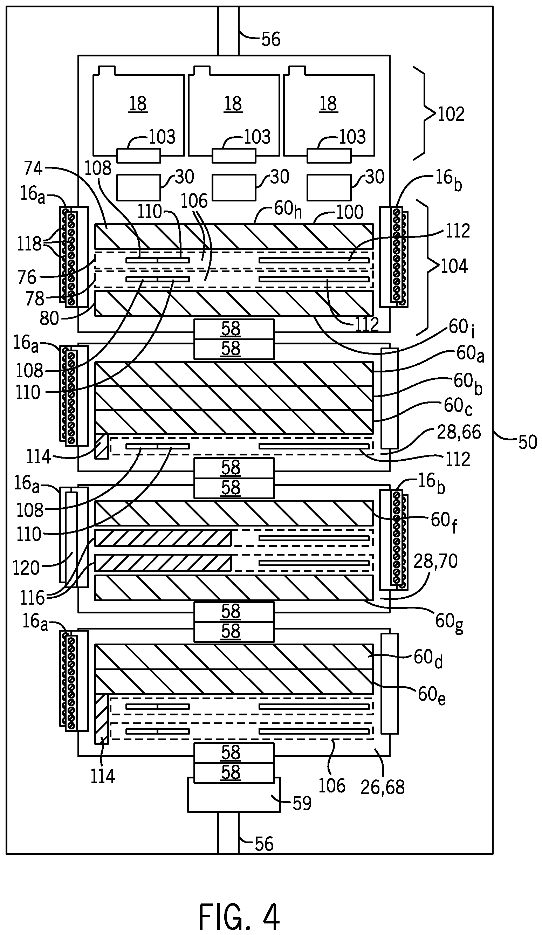

FIG. 4 illustrates an embodiment of a control panel 50 with an integrated head-carrier board 100. The integrated head-carrier board 100 has a head board portion 102 and a carrier board portion 104. The head board portion 102 may be substantially similar to the head board 14, and the carrier board portion 104 may be substantially similar to the carrier boards 28 described above. The integrated head-carrier board 100 may reduce the quantity of junctions 58 utilized in the controller system 10, thereby reducing costs and/or complexity of the controller system 10. The one or more processors 18 may be coupled to the head-carrier board 100 via head connectors 103. The head connectors 103 may be snaps or clips that facilitate removal and installation of the processors 18. In some embodiments, the head connectors 103 have electrical connections with the processors 18 and head board 14. In some embodiments, the processors 18 are hot-swappable, thereby enabling a processor 18 to be removed and/or replaced during operation. In some embodiments, the components of the integrated head-carrier board 100 receive power through multiple power supplies 30. For example, each power supply 30 may correspond to a respective processor 18.

The modularity and interchangeability of components of the controller system 10 improves the adaptability of the controller system 10 for a variety of applications. The head connectors 103 may enable the processors 18 to be readily replaced during operation of the head board 14 (e.g., hot-swapping the processors 18) and/or during a powered down maintenance period. In some embodiments, processors 18 may be removed and replaced to maintain or improve processing capabilities of the head board 14 or head portion 102. For example, the head connectors 103 may enable a first set of processors to be replaced with a second set of upgraded processors at a later date. The carrier boards 28 may be added or removed from the controller system 10 as respective sensors 12 and controlled devices 21 are added or removed from the controller system 10. The junctions 58 may facilitate the addition and removal of carrier boards 28 in series during operation of the controller system 10 and/or during a powered down maintenance period. The acquisition modules 60 may be added or removed from each carrier board 28 via the connectors 74, 76, 78, 80 to adjust the redundancy mode of the respective carrier board 28 during operation of the controller system 10 and/or during a maintenance period. Some embodiments of the controller system 10 provide flexibility to adjust the redundancy mode during operation. For example, it may be desirable to have a first redundancy mode (e.g., triple redundancy) of a carrier board 28 during a first monitoring period (e.g., startup period, maintenance period), and a second redundancy mode (e.g., simplex) during a second monitoring period (e.g., stead state operation period).

Connectors 106 of the carrier board portion 104 and the carrier boards 28 may distribute power and transmit signals between the acquisition modules 60 and the head portion 102. The connectors 106 may mechanically and/or electrically interface with the acquisition modules 60. For example, the connectors 106 may interface with the acquisition modules via mating geometries (e.g., posts and sockets, cards and slots, etc.) The carrier board portion 104 and the carrier boards 28 of FIG. 4 each have four connectors 106, although other embodiments may have different quantities of connectors 106 (e.g., 1, 2, 3, 5, 6, or more). The connectors 106 may be arranged adjacent to one another. The connectors 106 connect the terminal blocks 16 and junctions 58 to the acquisition modules 60. In some embodiments, the connectors 106 are arranged in sets with a first set of connectors (e.g., connectors 74, 76, 78) connected to the first terminal block 16a, and a second set of connectors (e.g., connector 80) connected to the second terminal block 16b. In some embodiments, each connector 106 may have a power port 108, a communications port 110, and an input-output (I/O) port 112. Acquisition modules 60 are coupled to a terminal block 16 via coupling with a connector 106. For example, acquisition modules 60h and 60i are respectively coupled to the connectors 74 and 80 of the integrated head-carrier board 100 in simplex mode, and the connectors 76, 78 are vacant.

The physical arrangement of the acquisition modules 60 to the connectors 106 may automatically configure the carrier board 28 in a particular redundancy mode. A first set of connectors 74, 76, 78 may be connected to the first terminal block 16a, and a second set of connectors 80 may be connected to the second terminal block 16b. Connecting one acquisition module 60 to a connector of a terminal block 16 may automatically configure the carrier board 28 in a simplex mode. For example, acquisition module 60f is connected in simplex mode to the connector 74 of the third carrier board 70, the acquisition module 60g is connected in simplex mode to the connector 80 of the third carrier board 70, the acquisition module 60h is connected in simplex mode to the connector 74 of the head-carrier board 100, and the acquisition module 60i is connected in simplex mode to the connectors 80 of the head-carrier board 100. Connecting multiple acquisition modules 60 to a terminal block 16 may automatically configure the respective carrier board 28 in a dual or triple redundancy mode. For example, the first carrier board 66 is configured in triple redundancy mode with the three connected acquisition modules 60a, 60b, 60c, and the second carrier board 68 is configured in dual redundancy mode with the two connected acquisition modules 60d, 60e. Changing the quantity and/or physical arrangement of the acquisition modules 60 on a carrier board 28 may change the redundancy mode of the carrier board 28. In some embodiments, hot-swappable acquisition modules 60 may be removed or replaced during operation of the carrier board 28.

The connectors 106 may automatically configure the carrier board 28 in a particular redundancy mode based at least in part on the connection of acquisition modules 60 to the terminal blocks 16a, 16b via the connectors 74, 76, 78, 80. In some embodiments, the carrier board 28 communicates a redundancy mode signal to the head board 14, such as when acquisition modules 60 are connected. Each of the processors 18 may be configured to communicate with each acquisition module 60 of a respective carrier board 28 in any redundancy mode. Executable instructions for the head board 14 may control each processor 18 to determine the redundancy mode of the carrier board 28 based at least in part on the data signals received from the acquisition modules 60. For example, if a processor 18 receives two data signals from a carrier board 28, the head board 14 may determine the two acquisition modules 60 are connected in dual redundancy mode if the data signals have similar parameters (e.g., voltage range, current range, sample rate), and the head board 14 may determine the two acquisition modules 60 are each connected in simplex mode if the data signals have different parameters. Additionally, or in the alternative, the carrier board 28 may provide a redundancy mode signal to the head board 14 to indicate the respective redundancy mode.

In some embodiments, mechanical blocking features may substantially block the addition of acquisition modules 60 to one or more particular connectors of a carrier board 28. Blocking features may indicate a current redundancy mode of a carrier board 28 and block the addition of acquisition modules 60 that may change the current redundancy mode. For example, the first carrier board 66 may be configured in triple redundancy mode, and the first carrier board 66 may not support more than three acquisition modules 60 and/or may not support different concurrent redundancy modes (e.g., triple redundancy mode and simplex mode). The third acquisition module 60c may have a blocking feature 114 (e.g., post, cover, shield, mechanical barrier) that extends over a portion of the connector 80, thereby substantially mechanically blocking the addition of another acquisition module 60. In some embodiments, the blocking feature 114 is on each acquisition module 60. In some embodiments, the blocking feature 114 is an adjustable geometry, such as a fold-out portion of the acquisition module 60, a telescopic post, a hinged structure. Some embodiments of the blocking feature 114 may enable the acquisition module 60e of the second carrier board 68 in a dual redundancy mode to block the addition of another acquisition module 60 to the connectors 78 and 80. In some embodiments, mechanical spacers 116 may be placed on vacant connectors (e.g., connectors 76, 78 of the third carrier board 70) to block additional acquisition modules 60.

Connectors 106 communicatively couple the I/O ports 112 to terminals 118 of the terminal blocks 16. The terminals 118 may be arranged in groups (e.g., channels), where each channel has one or more terminals 118. Each terminal 118 or channel is associated with a terminal block 16. In some embodiments, the association of a terminal 118 with a terminal block 16 may be adjustable. In some embodiments, each channel has three electrical terminals 118, such as a power terminal, positive terminal, and a negative terminal. Each sensor 12 or controlled device 21 may couple with one or more channels of a terminal block 16, thereby connecting to multiple terminals 118. For example, 48 terminals 118 of the first terminal block 16a may be arranged into 16 channels with 3 terminals 118 per channel. In some embodiments, an acquisition module 60 may be configured to couple with multiple sensors 12 and/or controlled devices 21 via multiple channels of a terminal block 16. For example, the first terminal block 16a may connect two or more sensors 12 on two or more channels to redundant acquisition modules 60 on the connectors 74, 76, 78. The terminals 118 may have fasteners, including, but not limited to screws, as shown on the terminal blocks 16a, 16b of the head-carrier board 100. In some embodiments, the terminal blocks 16a, 16b may couple with sensors via a wire harness 120 (e.g., crimp pins and shells).

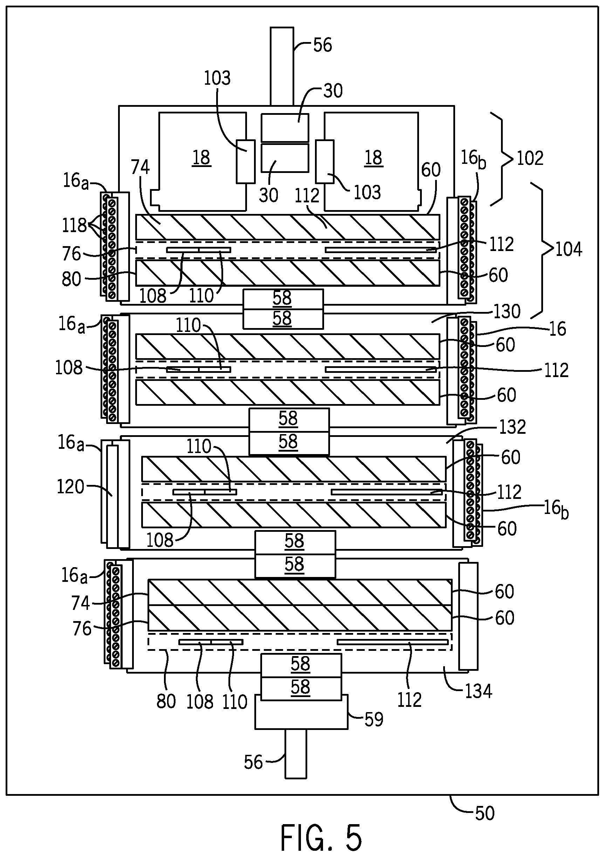

FIG. 5 illustrates another embodiment of an integrated head-carrier board 100. The carrier portion 104 and the carrier boards 28 coupled to the head-carrier board 100 have fewer connectors 106 (e.g., connectors 74, 76, 80) than the embodiment of FIG. 4 (e.g., connectors 74, 76, 78, 80). The connectors 74, 76 are connected to the first terminal block 16a, and the connector 80 is connected to the second terminal block 16b. The head-carrier portion 104, second carrier board 130, and a third carrier board 132 are each configured in simplex mode with two acquisition modules 60. In the simplex mode, each acquisition module 60 may receive feedback signals from different sensors, and/or each acquisition module 60 may be independent of the other acquisition module 60 of the same carrier board. A fourth carrier board 134 in dual redundancy mode has two acquisition modules 60d, 60e. The acquisition modules 60d, 60e redundantly receive raw feedback signals from the same one or more sensors coupled to the first terminal block 16a.

In some embodiments, carrier boards 28 with different quantities of connectors 106 may be connected to the same head carrier 14 or head-carrier board 100. For example, the carrier boards 28 of FIG. 5 may be connected to the carrier boards 28 of FIG. 4 via the junctions 58. The various quantities of connectors 106 enable an operator to select a desired redundancy level for a carrier board 28, thereby minimizing the quantity of vacant connectors 106 on carrier boards 28. Additionally, carrier boards 28 with fewer connectors 106 may be smaller than carrier boards 28 with more connectors. In some embodiments, more carrier boards 28 (e.g., carrier boards 130, 132, 134 of FIG. 5) with three connectors 106 may be assembled on a control panel 50 and connected to a head board 14 than the quantity of carrier boards 28 (e.g., carrier boards 66, 68, 70 of FIG. 4) with more than three connectors 106 that may be connected to a head board 14 with a limited space (e.g., control cabinet).

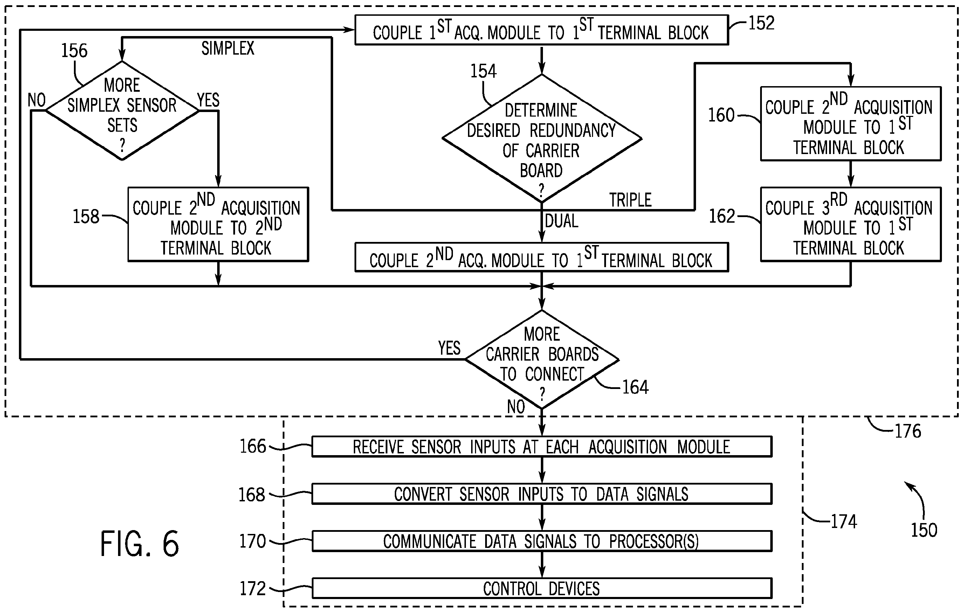

FIG. 6 illustrates a method 150 for assembling and operating the controller system. A first acquisition module is coupled (block 152) to a terminal block of a carrier board. As discussed above, the first acquisition module is coupled to the first terminal block of the carrier board via a connector. The user then determines (node 154) the desired redundancy for the carrier board. The available redundancy modes may be based at least in part on the type of carrier board and the number of connectors. Upon determination of simplex mode at node 154, the operator determines (node 156) whether one or more sets of sensors or controlled devices are to be connected to separate terminal blocks. If a second set of sensors or controlled devices is to be connected, a second acquisition module is coupled (block 158) to the second terminal block of the carrier board in a simplex mode. Upon determination of dual redundancy at node 154, the operator couples (block 160) a second acquisition module to the first terminal block to be redundant with the first acquisition module. Upon determination of triple redundancy at node 154, the operator couples (block 160) a second acquisition module to the first terminal block, and the operator couples (block 162) a third acquisition module to the first terminal block. Both the second and third acquisition modules are redundant with the first acquisition module in the triple redundancy mode. As may be appreciated, an operator may configure a carrier board with additional redundancy modes in a similar manner to configuring in the triple redundancy mode.

After coupling additional acquisition modules in the desired redundancy mode for the carrier board, the operator determines (node 164) whether to connect additional carrier boards and sensors sets to the head board. If additional carrier boards are to be connected (e.g., via junctions) to the head board, then the method 150 repeats from block 152. If no additional carrier boards are to be connected, then the coupled acquisition modules may receive (block 166) raw feedback signals from the one or more connected sensor sets. The acquisition modules convert (block 168) the raw feedback signals to data signals, and communicate (block 170) the data signals to the one or more processors on the head board. The one or more processors of the head board may control (block 172) devices (e.g., compressor, turbine, combustor, reactor) based at least in part on the data signals. After assembly, the operating steps 174 may repeat until the controller assembly is powered down.

In some embodiments, the acquisition modules, carrier boards, and/or processors may be hot-swappable, thereby enabling removal or replacement during operation of the controller assembly. Hot-swappable components may reduce downtime of the controller assembly due to maintenance, thereby reducing operating costs. In some embodiments, the redundancy configurations of the acquisition modules and/or the processors may be adjusted during operation. Thus, one or more of assembly steps 176 may occur before or between the operating steps 174 of the method 150. The operating steps 174 may be performed by the assembled controller system. A user performs the assembly steps 176 to assemble the controller system prior to initial operation, and may perform subsequent assembly steps 176 to maintain the controller system.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A data acquisition system comprising:
a head board (14) comprising a first head processor (52); and
a first carrier board (66) comprising:
a first terminal block (16a) communicatively coupled to the head board (14), a first connector (74), a second connector (76), and a third connector (78), wherein the first connector is configured to couple with a first acquisition module in a first simplex mode, a first dual redundancy mode, or a first triple redundancy mode, the second connector is configured to couple with a second acquisition module in the first dual redundancy mode or the first triple redundancy mode, and the third connector is configured to couple with a third acquisition module in the first triple redundancy mode; and
a second terminal block (16b) communicatively coupled to the head board (14) and to a fourth connector (80), wherein the fourth connector is configured to couple with the second acquisition module in the first simplex mode.

2. The data acquisition system of claim 1, wherein the head board (14) comprises a plurality of processors (52, 54), wherein each processor of the plurality of processors (52, 54) is coupled to at least two connectors of the first connector, the second connector, the third connector, and the fourth connector, and wherein each processor shares a redundant coupling with another processor of the plurality of processors (52, 54).

3. The data acquisition system of claim 1 or claim 2, comprising the first acquisition module (60) and the second acquisition module (60), wherein, preferably, the first acquisition module is configured to receive a first discrete signal or a first analog signal, and the second acquisition module is configured to receive a second discrete signal or a second analog signal.

4. The data acquisition system of claim 1, 2 or 3, wherein the second acquisition module (60) coupled to the second connector in the first dual redundancy mode or the third acquisition module coupled to the third connector in the first triple redundancy mode is configured to substantially block a fourth acquisition module from coupling to the fourth connector.

5. The data acquisition system of any one of claims 1 to 4, comprising:
a second carrier board (68, 70) communicatively coupled to the first carrier board (66) and the head board (14), wherein the second carrier board (68, 70) comprises:
a third terminal block communicatively coupled to the head board (14), a fifth connector, a sixth connector, and a seventh connector, wherein the fifth connector is configured to couple with a fourth acquisition module in a second simplex mode, a second dual redundancy mode, or a second triple redundancy mode, the sixth connector is configured to couple with a fifth acquisition module in the second dual redundancy mode or the second triple redundancy mode, and the seventh connector is configured to couple with a sixth acquisition module in the second triple redundancy mode; and
a fourth terminal block communicatively coupled to the head board (14) and to an eighth connector, wherein the eighth connector is configured to couple with the fourth acquisition module in the second simplex mode.

6. The system of any preceding claim, wherein the first carrier board (66) is integrated with the head board (14).

7. The system of claim any preceding claim, wherein the first attachment pattern comprises the one or more first acquisition modules (60) coupled to the first plurality of connectors, and the first carrier board (66) is configured in the first simplex mode, a dual redundant mode, or a triple redundant mode, wherein, preferably, the first carrier board (66) comprises a second plurality of connectors configured to communicatively couple the head board (14) to the one or more first acquisition modules (60) with the first attachment pattern, wherein a second acquisition module of the one or more first acquisition modules is coupled to the second plurality of connectors, and the first carrier board (66) is configured in the first simplex mode with respect to the second acquisition module.

8. The system of any preceding claim, wherein the first plurality of connectors (74) comprises programmable universal I/O channels configured to receive a thermocouple signal, an resistor temperature detector (RTD) signal, a voltage signal, a current signal, a highway addressable remote transducer (HART) input signal, a HART output signal, or any combination thereof.

9. The system of any preceding claim, comprising:
the second carrier board (68, 70) communicatively coupled to the first junction (58), wherein the second carrier board (68, 70) comprises a second plurality of connectors configured to communicatively couple the head board (14) to one or more second acquisition modules with a second attachment pattern, wherein the one or more second acquisition modules are configured in a second simplex or a second redundant configuration based at least in part on the second attachment pattern; and
a second junction (58) to removably couple the second carrier board (68, 70) with the terminator or to removably couple the second carrier board (68, 70) with a third carrier board (70, 68), wherein, preferably, the first junction (58) is configured to transmit power and communication signals between the head board (14) and the second carrier board (68, 70).

10. A method of operating a data acquisition system, comprising:
receiving (166) a first sensor feedback at a first carrier board;
processing (168) the first sensor feedback into first data signals with one or more first acquisition modules coupled to the first carrier board,
the first carrier board (66) comprising a first terminal block (16a) communicatively coupled to a head board (14), a first connector (74), a second connector (76), and a third connector (78), wherein the first connector is configured to couple with a first acquisition module in a first simplex mode, a first dual redundancy mode, or a first triple redundancy mode, the second connector is configured to couple with a second acquisition module in the first dual redundancy mode or the first triple redundancy mode, and the third connector is configured to couple with a third acquisition module in the first triple redundancy mode;
a second terminal block (16b) communicatively coupled to the head board (14) and to a fourth connector (80), wherein the fourth connector is configured to couple with the second acquisition module in the first simplex mode; and
communicating (170) the first data signals to one or more head processors.

11. The method of claim 10, comprising:
replacing an acquisition module of the one or more first acquisition modules with another acquisition module of the one or more first acquisition modules during operation of the data acquisition system, and/or
adjusting the first attachment pattern of the one or more first acquisition modules to the first carrier board during operation to change the first mode of the first carrier board, wherein adjusting the first attachment pattern comprises adding acquisition modules to the first carrier board, removing acquisition modules from the first carrier board, or rearranging the one or more first acquisition modules on the first carrier board.

12. The method of claim 10 or claim 11, comprising:
coupling a second carrier board to the first carrier board;
receiving a second sensor feedback at a second carrier board;
processing the second sensor feedback into second data signals with one or more second acquisition modules coupled to the second carrier board, wherein the second carrier board is configured in a second mode comprising the simplex mode or the redundant mode based at least in part on a second attachment pattern of the one or more second acquisition modules to the second carrier board, wherein the redundant mode directs the second sensor feedback to a second plurality of redundant acquisition modules of the one or more second acquisition modules; and
communicating the second data signals to the one or more head processors;
wherein, preferably, the first mode of the first carrier board is different from the second mode of the second carrier board.

## Patentansprüche

1. Datenerfassungssystem, das Folgendes umfasst:
eine Hauptleiterplatte (14), die einen ersten Hauptprozessor (52) umfasst; und
eine erste Trägerleiterplatte (66), die Folgendes umfasst:
einen ersten Anschlussblock (16a), der mit der Hauptleiterplatte (14) kommunikativ gekoppelt ist, ein erstes Verbindungselement (74), ein zweites Verbindungselement (76) und ein drittes Verbindungselement (78), wobei das erste Verbindungselement konfiguriert ist, in einem ersten Simplex-Modus, in einem ersten Zweifach-Redundanz-Modus oder in einem ersten Dreifach-Redundanz-Modus mit einem ersten Erfassungsmodul zu koppeln, das zweite Verbindungselement konfiguriert ist, im ersten Zweifach-Redundanz-Modus oder im ersten Dreifach-Redundanz-Modus mit einem zweiten Erfassungsmodul zu koppeln, und das dritte Verbindungselement konfiguriert ist, im ersten Dreifach-Redundanz-Modus mit einem dritten Erfassungsmodul zu koppeln; und
einen zweiten Anschlussblock (16b), der mit der Hauptleiterplatte (14) und mit einem vierten Verbindungselement (80) kommunikativ gekoppelt ist, wobei das vierte Verbindungselement konfiguriert ist, im ersten Simplex-Modus mit dem zweiten Erfassungsmodul zu koppeln.

2. Datenerfassungssystem nach Anspruch 1, wobei die Hauptleiterplatte (14) mehrere Prozessoren (52, 54) umfasst, wobei jeder Prozessor der mehreren Prozessoren (52, 54) mit mindestens zwei Anschlusselementen des ersten Anschlusselements, des zweiten Anschlusselements, des dritten Anschlusselements und des vierten Anschlusselements gekoppelt ist und wobei jeder Prozessor mit einem anderen Prozessor der mehreren Prozessoren (52, 54) eine redundante Kopplung teilt.

3. Datenerfassungssystem nach Anspruch 1 oder Anspruch 2, das das erste Erfassungsmodul (60) und das zweite Erfassungsmodul (60) umfasst, wobei vorzugsweise das erste Erfassungsmodul konfiguriert ist, ein erstes diskretes Signal oder ein erstes analoges Signal zu empfangen, und das zweite Erfassungsmodul konfiguriert ist, ein zweites diskretes Signal oder ein zweites analoges Signal zu empfangen.

4. Datenerfassungssystem nach Anspruch 1, 2 oder 3, wobei das zweite Erfassungsmodul (60), das im ersten Zweifach-Redundanz-Modus mit dem zweiten Verbindungselement gekoppelt ist, oder das dritte Erfassungsmodul, das im ersten Dreifach-Redundanz-Modus mit dem dritten Verbindungselement gekoppelt ist, konfiguriert ist, ein viertes Erfassungsmodul im Wesentlichen von der Kopplung mit dem vierten Verbindungselement abzublocken.

5. Datenerfassungssystem nach einem der Ansprüche 1 bis 4, das Folgendes umfasst:
eine zweite Trägerleiterplatte (68, 70), die mit der ersten Trägerleiterplatte (66) und der Hauptleiterplatte (14) kommunikativ gekoppelt ist, wobei die zweite Trägerleiterplatte (68, 70) Folgendes umfasst:
einen dritten Anschlussblock, der mit der Hauptleiterplatte (14) kommunikativ gekoppelt ist, ein fünftes Verbindungselement, ein sechstes Verbindungselement und ein siebentes Verbindungselement, wobei das fünfte Verbindungselement konfiguriert ist, in einem zweiten Simplex-Modus, in einem zweiten Zweifach-Redundanz-Modus oder in einem zweiten Dreifach-Redundanz-Modus mit einem vierten Erfassungsmodul zu koppeln, das sechste Verbindungselement konfiguriert ist, im zweiten Zweifach-Redundanz-Modus oder im zweiten Dreifach-Redundanz-Modus mit einem fünften Erfassungsmodul zu koppeln, und das siebente Verbindungselement konfiguriert ist, im zweiten Dreifach-Redundanz-Modus mit einem sechsten Erfassungsmodul zu koppeln; und
einen vierten Anschlussblock, der mit der Hauptleiterplatte (14) und mit einem achten Verbindungselement kommunikativ gekoppelt ist, wobei das achte Verbindungselement konfiguriert ist, im zweiten Simplex-Modus mit dem vierten Erfassungsmodul zu koppeln.

6. System nach einem der vorhergehenden Ansprüche, wobei die erste Trägerleiterplatte (66) mit der Hauptleiterplatte (14) einteilig ausgeführt ist.

7. System nach einem der vorhergehenden Ansprüche, wobei das erste Befestigungsmuster das eine oder die mehreren ersten Erfassungsmodule (60) mit den mehreren ersten Verbindungselementen gekoppelt umfasst und die erste Trägerleiterplatte (66) im ersten Simplex-Modus, in einem zweifach redundanten Modus oder in einem dreifach redundanten Modus konfiguriert ist, wobei die erste Trägerleiterplatte (66) vorzugsweise mehrere zweite Verbindungselemente umfasst, die konfiguriert sind, die Hauptleiterplatte (14) mit dem einen oder den mehreren ersten Erfassungsmodulen (60) mit dem ersten Befestigungsmuster kommunikativ zu koppeln, wobei ein zweites Erfassungsmodul des einen oder der mehreren ersten Erfassungsmodule mit den mehreren zweiten Verbindungselementen gekoppelt ist und die erste Trägerleiterplatte (66) im ersten Simplex-Modus in Bezug auf das zweite Erfassungsmodul konfiguriert ist.

8. System nach einem der vorhergehenden Ansprüche, wobei die mehreren ersten Verbindungselemente (74) programmierbare Universal-Eingangs-/Ausgangs-Kanäle umfassen, die konfiguriert sind, ein Signal eines Thermoelements, ein Signal eines Widerstandstemperaturdetektors (RTD-Signal), ein Spannungssignal, ein Stromsignal, ein Eingangssignal eines highwayadressierbaren Fernsignalgebers (HART-Signal), ein HART-Ausgangssignal oder eine beliebige Kombination davon zu empfangen.

9. System nach einem der vorhergehenden Ansprüche, das Folgendes umfasst:
die zweite Trägerleiterplatte (68, 70), die mit dem ersten Knotenpunkt (58) kommunikativ gekoppelt ist, wobei die zweite Trägerleiterplatte (68, 70) mehrere zweite Verbindungselemente umfasst, die konfiguriert sind, die Hauptleiterplatte (14) mit einem oder mehreren zweiten Erfassungsmodulen in einem zweiten Befestigungsmuster kommunikativ zu koppeln, wobei das eine oder die mehreren zweiten Erfassungsmodule zumindest teilweise auf der Basis des zweiten Befestigungsmusters in einer zweiten Simplex-Konfiguration oder in einer zweiten redundanten Konfiguration konfiguriert sind; und
einen zweiten Knotenpunkt (58), um die zweite Trägerleiterplatte (68, 70) mit dem Abschlusswiderstand abnehmbar zu koppeln oder die zweite Trägerleiterplatte (68, 70) mit einer dritten Trägerleiterplatte (70, 68) abnehmbar zu koppeln, wobei der erste Knotenpunkt (58) vorzugsweise konfiguriert ist, zwischen der Hauptleiterplatte (14) und der zweiten Trägerleiterplatte (68, 70) Leistungs- und Kommunikationssignale zu übertragen.

10. Verfahren zum Betreiben eines Datenerfassungssystems, das Folgendes umfasst:
Empfangen (166) einer ersten Sensorrückmeldung an einer ersten Trägerleiterplatte;
Verarbeiten (168) der ersten Sensorrückmeldung in erste Datensignale, wobei ein oder mehrere erste Erfassungsmodule mit der ersten Trägerleiterplatte gekoppelt sind,
wobei die erste Trägerleiterplatte (66) einen ersten Anschlussblock (16a), der mit einer Hauptleiterplatte (14) kommunikativ gekoppelt ist, ein erstes Verbindungselement (74), ein zweites Verbindungselement (76) und ein drittes Verbindungselement (78) umfasst, wobei das erste Verbindungselement konfiguriert ist, in einem ersten Simplex-Modus, in einem ersten Zweifach-Redundanz-Modus oder in einem ersten Dreifach-Redundanz-Modus mit einem ersten Erfassungsmodul zu koppeln, das zweite Verbindungselement konfiguriert ist, im ersten Zweifach-Redundanz-Modus oder im ersten Dreifach-Redundanz-Modus mit einem zweiten Erfassungsmodul zu koppeln, und das dritte Verbindungselement konfiguriert ist, im ersten Dreifach-Redundanz-Modus mit einem dritten Erfassungsmodul zu koppeln;
einen zweiten Anschlussblock (16b), der mit der Hauptleiterplatte (14) und mit einem vierten Verbindungselement (80) kommunikativ gekoppelt ist, wobei das vierte Verbindungselement konfiguriert ist, im ersten Simplex-Modus mit dem zweiten Erfassungsmodul zu koppeln; und
Kommunizieren (170) der ersten Datensignale an einen oder mehrere Hauptprozessoren.

11. Verfahren nach Anspruch 10, das Folgendes umfasst:
Ersetzen eines Erfassungsmoduls des einen oder der mehreren ersten Erfassungsmodule durch ein anderes Erfassungsmodul des einen oder der mehreren ersten Erfassungsmodule während des Betriebs des Datenerfassungssystems, und/oder
Einstellen des ersten Befestigungsmusters des einen oder der mehreren ersten Erfassungsmodule an der ersten Trägerleiterplatte während des Betriebs, um den ersten Modus der ersten Trägerleiterplatte zu ändern, wobei das Einstellen des ersten Befestigungsmusters das Hinzufügen von Erfassungsmodulen zur ersten Trägerleiterplatte, das Entfernen von Erfassungsmodulen von der ersten Trägerleiterplatte oder das Neuanordnen des einen oder der mehreren ersten Erfassungsmodule auf der ersten Trägerleiterplatte umfasst.

12. Verfahren nach Anspruch 10 oder Anspruch 11, das Folgendes umfasst:
Koppeln einer zweiten Trägerleiterplatte mit der ersten Trägerleiterplatte;
Empfangen einer zweiten Sensorrückmeldung an einer zweiten Trägerleiterplatte;
Verarbeiten der zweiten Sensorrückmeldung in zweite Datensignale, wobei ein oder mehrere zweite Erfassungsmodule mit der zweiten Trägerleiterplatte gekoppelt sind, wobei die zweite Trägerleiterplatte zumindest teilweise auf der Basis eines zweiten Befestigungsmusters des einen oder der mehreren zweiten Erfassungsmodule an der zweiten Trägerleiterplatte in einem zweiten Modus konfiguriert ist, der den Simplex-Modus oder den redundanten Modus umfasst, wobei der redundante Modus die zweite Sensorrückmeldung zu mehreren zweiten redundanten Erfassungsmodulen des einen oder der mehreren zweiten Erfassungsmodule leitet; und
Kommunizieren der zweiten Datensignale an den einen oder die mehreren Hauptprozessoren;
wobei der erste Modus der ersten Trägerleiterplatte vorzugsweise vom zweiten Modus der zweiten Trägerleiterplatte verschieden ist.

## Revendications

1. Système d'acquisition de données comprenant :
- une carte de tête (14) comprenant un premier processeur de tête (52) ; et
- une première carte de support (66) comprenant :
- un premier bloc de borne (16a) couplé en communication à la carte de tête (14), un premier connecteur (74), un second connecteur (76) et un troisième connecteur (78), dans lequel le premier connecteur est conçu pour se coupler à un premier module d'acquisition dans un premier mode simplex, un premier mode de redondance double ou un premier mode de redondance triple, le second connecteur est conçu pour se coupler à un second module d'acquisition dans le premier mode de redondance double ou le premier mode de redondance triple, et le troisième connecteur est conçu pour se coupler à un troisième module d'acquisition dans le premier mode de redondance triple ; et
- un second bloc de borne (16b) couplé en communication à la carte de tête (14) et à un quatrième connecteur (80), dans lequel le quatrième connecteur est conçu pour se coupler au second module d'acquisition dans le premier mode simplex.

2. Système d'acquisition de données selon la revendication 1, dans lequel la carte de tête (14) comprend plusieurs processeurs (52, 54), dans lequel chaque processeur parmi les plusieurs processeurs (52, 54) est couplé à au moins deux connecteurs parmi le premier connecteur, le second connecteur, le troisième connecteur et le quatrième connecteur, et dans lequel chaque processeur partage un couplage redondant avec un autre processeur parmi les plusieurs processeurs (52, 54).

3. Système d'acquisition de données selon la revendication 1 ou la revendication 2, comprenant le premier module d'acquisition (60) et le second module d'acquisition (60), et dans lequel, de préférence, le premier module d'acquisition est conçu pour recevoir un premier signal discret ou un premier signal analogique, et le second module d'acquisition est conçu pour recevoir un second signal discret ou un second signal analogique.

4. Système d'acquisition de données selon les revendications 1, 2 ou 3, dans lequel le second module d'acquisition (60) couplé au second connecteur dans le premier mode de redondance double ou le troisième module d'acquisition couplé au troisième connecteur dans le premier mode de redondance triple est conçu pour essentiellement empêcher un quatrième module d'acquisition de se coupler au quatrième connecteur.

5. Système d'acquisition de données selon l'une quelconque des revendications 1 à 4, comprenant :
- une seconde carte de support (68, 70) couplée en communication avec la première carte de support (66) et la carte de tête (14), dans lequel la seconde carte de support (68, 70) comprend :
- un troisième bloc de borne couplé en communication avec la carte de tête (14), un cinquième connecteur, un sixième connecteur et un septième connecteur, dans lequel le cinquième connecteur est conçu pour se coupler à un quatrième module d'acquisition dans un second mode simplex, un second mode de redondance double ou un second mode de redondance triple, le sixième connecteur est conçu pour se coupler à un cinquième module d'acquisition dans le second mode de redondance double ou le second mode de redondance triple, et le septième connecteur est conçu pour se coupler à un sixième module d'acquisition dans le second mode de redondance triple ; et
- un quatrième bloc de borne couplé en communication à la carte de tête (14) et à un huitième connecteur, dans lequel le huitième connecteur est conçu pour se coupler au quatrième module d'acquisition dans le second mode simplex.

6. Système selon l'une quelconque des revendications précédentes, dans lequel la première carte de support (66) est intégrée à la carte de tête (14).

7. Système selon l'une quelconque des revendications précédentes, dans lequel le premier motif de fixation comprend le ou les premiers modules d'acquisition (60) couplés aux premiers plusieurs connecteurs, et la première carte de support (66) est configurée dans le premier mode simplex, un mode de redondance double ou un mode de redondance triple, et dans lequel, de préférence, la première carte de support (66) comprend plusieurs seconds connecteurs conçus pour coupler en communication la carte de tête (14) au ou aux premiers modules d'acquisition (60) avec le premier motif de fixation, dans lequel un second module d'acquisition du ou des premiers modules d'acquisition est couplé aux plusieurs seconds connecteurs, et la première carte de support (66) est configurée dans le premier mode simplex par rapport au second module d'acquisition.

8. Système selon l'une quelconque des revendications précédentes, dans lequel les plusieurs premiers connecteurs (74) comprennent des canaux I/O universels programmables conçus pour recevoir un signal de thermocouple, un signal de détecteur de température de résistance (RTD), un signal de tension, un signal de courant, un signal d'entrée de transducteur distant adressable rapide (HART), un signal de sortie HART, ou une quelconque combinaison de ceux-ci.

9. Système selon l'une quelconque des revendications précédentes, comprenant :
- la seconde carte de support (68, 70) couplée en communication avec la première jonction (58), la seconde carte de support (68, 70) comprenant plusieurs seconds connecteurs conçus pour coupler en communication la carte de tête (14) à un ou plusieurs seconds modules d'acquisition avec un second motif de fixation, dans lequel le ou les seconds modules d'acquisition sont configurés dans une seconde configuration simplex ou une seconde configuration de redondance en fonction au moins en partie du second motif de fixation ; et
- une seconde jonction (58) pour coupler de manière amovible la seconde carte de support (68, 70) avec la terminaison ou pour coupler de manière amovible la seconde carte de support (68, 70) avec une troisième carte de support (70, 68), dans lequel, de préférence, la première jonction (58) est conçue pour transmettre des signaux d'alimentation et de communication entre la carte de tête (14) et la seconde carte de support (68, 70).

10. Procédé de fonctionnement d'un système d'acquisition de données, consistant à :
- recevoir (166) un premier retour de capteur au niveau d'une première carte de support ;
- traiter (168) le premier retour de capteur en premiers signaux de données avec un ou plusieurs premiers modules d'acquisition couplés à la première carte de support ;
- la première carte de support (66) comprenant un premier bloc de borne (16a) couplé en communication à la carte de tête (14), un premier connecteur (74), un second connecteur (76) et un troisième connecteur (78), dans lequel le premier connecteur est conçu pour se coupler à un premier module d'acquisition dans un premier mode simplex, un premier mode de redondance double ou un premier mode de redondance triple, le second connecteur est conçu pour se coupler à un second module d'acquisition dans le premier mode de redondance double ou le premier mode de redondance triple, et le troisième connecteur est conçu pour se coupler à un troisième module d'acquisition dans le premier mode de redondance triple ;
- un second bloc de borne (16b) couplé en communication à la carte de tête (14) et à un quatrième connecteur (80), dans lequel le quatrième connecteur est conçu pour se coupler au second module d'acquisition dans le premier mode simplex ; et
- communiquer (170) les premiers signaux de données à un ou plusieurs processeurs de tête.

11. Procédé selon la revendication 10, consistant à :
- remplacer un module d'acquisition parmi le ou les premiers modules d'acquisition par un autre module d'acquisition parmi le ou les premiers modules d'acquisition pendant le fonctionnement du système d'acquisition de données ; et/ou
- ajuster le premier motif de fixation du ou des premiers modules d'acquisition sur la première carte de support pendant le fonctionnement afin de changer le premier mode de la première carte de support, dans lequel l'ajustement du premier motif de fixation consiste à ajouter des modules d'acquisition à la première carte de support, retirer des modules d'acquisition de la première carte de support, ou ré-agencer le ou les premiers modules d'acquisition sur la première carte de support.

12. Procédé selon la revendication 10 ou la revendication 11, consistant à :
- coupler une seconde carte de support à la première carte de support ;
- recevoir un second retour de capteur au niveau d'une seconde carte de support ;
- traiter le second retour de capteur en seconds signaux de données avec un ou plusieurs seconds modules d'acquisition couplés à la seconde carte de support, dans lequel la seconde carte de support est configurée dans un second mode comprenant le mode simplex ou le mode de redondance en fonction au moins en partie d'un second motif de fixation du ou des seconds modules d'acquisition à la seconde carte de support, dans lequel le mode de redondance dirige le second retour de capteur vers plusieurs seconds modules d'acquisition redondants parmi le ou les seconds modules d'acquisition ; et
- communiquer les seconds signaux de données au ou aux processeurs de tête ;
dans lequel, de préférence, le premier mode de la première carte de support est différent du second mode de la seconde carte de support.
